# EUROPÄISCHE PATENTSCHRIFT

(11) **EP 3 215 310 B1**
(45) Veröffentlichungstag und Bekanntmachung des Hinweises auf die Patenterteilung: **04.09.2019**
(21) Anmeldenummer: 15794520.5
(22) Anmeldetag: 09.11.2015
(51) Int. Cl.: B23K 26/22, B23K 26/32, H01R 4/02, H01R 43/02, H05K 3/32, B23K 26/244, B23K 101/34, B23K 101/42, B23K 103/12, B23K 103/16

(54) **VERFAHREN ZUM BEARBEITEN EINES ERSTEN BAUELEMENTS UND EINES ZWEITEN BAUELEMETENS DURCH LASERSCHWEISSEN SOWIE ENTSPRECHENDE VORRICHTUNG**
METHOD OF WORKING A FIRST COMPONENT AND A SECOND COMPONENT BY LASER WELDING AND CORRESPONDING DEVICE
PROCÉDÉ DE TRAITEMENT D'UN PREMIER COMPOSANT ET D'UN SECOND COMPOSANT PAR SOUDAGE LASER ET DISPOSITIF ASSOCIÉ

(30) Priorität: 07.11.2014 DE 102014116283
(43) Veröffentlichungstag der Anmeldung: 13.09.2017
(73) Patentinhaber: Webasto SE, 82131 Stockdorf (DE)
(72) Erfinder: KABELITZ, Thorsten, 82131 Stockdorf (DE); LIPP, Jürgen, 82131 Stockdorf (DE); SCHMIDMAYER, Andreas, 82131 Stockdorf (DE); WEGENER, Fritz, 82131 Stockdorf (DE); HOLZWARTH, Achim, 82131 Stockdorf (DE); BUCKL, Stephan, 82131 Stockdorf (DE); KLINKMÜLLER, Tino, 82131 Stockdorf (DE); REUTER, Andreas, 82131 Stockdorf (DE); GÖTTL, Karl, 82131 Stockdorf (DE); ECKERT, Daniel, 82131 Stockdorf (DE)
(74) Vertreter: Epping - Hermann - Fischer
(86) Internationale Anmeldenummer: PCT/EP2015/076067
(87) Internationale Veröffentlichungsnummer: WO 2016/071533

(56) Entgegenhaltungen:
- DE-A1- 4 330 975
- DE-A1-102006 017 675
- JP-A- H0 794 845
- JP-A- H11 215 652
- US-A1- 2007 172 980
- US-A1- 2011 081 229

## Beschreibung

Zum Verbinden von Bauteilen gibt es verschiedene Kontaktierungsverfahren wie Löten, Mikrowiderstandsschweißen und Laserstrahlschweißen. Durch diese Kontaktierungsverfahren sind beispielsweise mechanische Verbindungen und/oder elektrisch leitfähige Verbindungen herstellbar. Laserstrahlschweißen wird beispielsweise zum Fügen von zwei Vollmaterialien eingesetzt, um diese stoffschlüssig zu verbinden. Das Laserstrahlschweißen wird industriell vor allem für Materialien wie Edelstahl verwendet, die insbesondere wenig stark reflektieren.

Dokument US 2007/0172980 A1 beschreibt die elektrische Anbindung von MOSFETs. Kontaktelemente werden dabei auf Elektroden aufgeschweißt.

Dokument US 2011/081229 A1 beschreibt das Abscheiden von Sensoren mittels Beschichten durch Aufsprühen.

Dokument DE 4330975 beschreibt das Herstellen einer Metallschicht auf einem Leistungsbauelement mittels eines Plasmaspritzverfahrens.

Dokument JP H07 94845 A betrifft ein Kontaktieren eines Halbleiterelements. Eine Spitze einer Zuleitung ist in der Dicke dünner ausgebildet als der andere Teil der Zuleitung.

Dokument JP H11 215652 A betrifft ein Schweißverfahren für einen Flachstecker.

DE 10 2006 017 675 A1, darstellend den Stand der Technik, betrifft eine Glasscheibe mit einem Heizelement und ein Verfahren zum Bearbeiten eines ersten Bauelements und eines zweiten Bauelements für ein Heizgerät für ein Kraftfahrzeug, umfassend Bereitstellen des ersten Bauelements, das eine elektrisch leitfähige Schicht umfasst, wobei die elektrisch leitfähige Schicht als Kontaktpad zur elektrischen und/ oder mechanischen Kontaktierung einer Heizleiterschicht dient, Bereitstellen des zweiten Bauelements (102), das einen länglich ausgedehnten Streifen aus Kupfer aufweist, der zumindest in einem ersten Bereich eine Dicke quer zur Längsrichtung von mehr als 0,1 Millimeter aufweist, Anordnen des Streifens und der Schicht aufeinander, so dass der erste Bereich des Streifens und die Schicht einen gemeinsamen Kontaktbereich miteinander aufweisen, Ausbilden einer Lötverbindung, die den Streifen und die Schicht miteinander verbindet.

Es ist wünschenswert, ein Verfahren zum Bearbeiten eines ersten und eines zweiten Bauelements anzugeben, das eine verlässliche Verbindung ermöglicht, wenn zumindest eines der Bauelemente Kupfer aufweist. Es ist zudem wünschenswert, eine Vorrichtung anzugeben, die eine verlässliche Verbindung eines Bauteils aus Kupfer auf einem weiteren Bauteil ermöglicht. Gemäß Ausführungsformen der Erfindung umfasst ein Verfahren die Merkmale des Anspruchs 1. Das Verfahren dient zum Bearbeiten eines ersten Bauelements und eines zweiten Bauelements für ein Heizgerät für ein Kraftfahrzeug ein Bereitstellen des ersten Bauelements, das eine thermisch gespritzte elektrisch leitfähige Schicht umfasst. Das zweite Bauelement wird bereitgestellt, das einen länglich ausgedehnten Streifen aus Kupfer aufweist. Der Streifen weist zumindest in einem ersten Bereich eine Dicke quer zur Längsrichtung von mehr als 0,1 mm auf. Gemäß weiteren Ausführungsformen weist der Streifen eine Dicke quer zur Längsrichtung von mehr als 0,2 mm auf. Gemäß weiteren Ausführungsformen weist der Streifen eine Dicke quer zur Längsrichtung von mehr als 0,3 mm auf. Gemäß weiteren Ausführungsformen weist der Streifen eine Dicke quer zur Längsrichtung von mehr als 0,4 mm auf. Gemäß weiteren Ausführungsformen weist der Streifen eine Dicke quer zur Längsrichtung von mehr als 0,5 mm auf. Gemäß weiteren Ausführungsformen weist der Streifen eine Dicke quer zur Längsrichtung von mehr als 0,6 mm auf. Gemäß weiteren Ausführungsformen weist der Streifen eine Dicke quer zur Längsrichtung von mehr als 1 mm auf. Gemäß weiteren Ausführungsformen weist der Streifen eine Dicke von weniger als 2 mm auf. Gemäß weiteren Ausführungsformen weist der Streifen eine Dicke quer zur Längsrichtung von mehr als 0,4 mm und weniger als 0,7 mm auf. Der Streifen und die Schicht werden aufeinander angeordnet, so dass der erste Bereich des Streifens und die Schicht einen gemeinsamen Kontaktbereich miteinander aufweisen. Ein Laserstrahl wird auf den Kontaktbereich eingestrahlt und dadurch wird eine Schweißverbindung ausgebildet. Die Schweißverbindung verbindet den Streifen und die Schicht miteinander.

Der Streifen, der Kupfer aufweist, wird mit der thermisch gespritzten elektrisch leitfähigen Schicht verschweißt. Dabei ist es möglich, einen verhältnismäßig dicken Streifen zu verwenden, der zumindest in dem ersten Bereich die Dicke quer zur Längsrichtung von mehr als 0,1 mm aufweist. Durch die Verwendung des verhältnismäßig dicken Streifens ist es möglich auch bei Hochvoltanwendungen in Kraftfahrzeugen, beispielsweise von mehr als 100 V, eine ausreichende Stromtragfähigkeit des Streifens zu gewährleisten. Im Betrieb ist der Streifen und/oder die Schicht und/oder die Verbindung des Streifens mit der Schicht dazu ausgebildet, um einen Stromfluss zwischen Streifen und Schicht von insbesondere mindestens 15 Ampere verlässlich zu ermöglichen, insbesondere einen Stromfluss von mindestens 20 Ampere, insbesondere einen Stromfluss von mindestens 25 Ampere, insbesondere einen Stromfluss von mindestens 30 Ampere. Der Streifen weist beispielsweise zumindest bereichsweise eine Querschnittsfläche von mehr als 1,5 Quadratmillimeter auf, insbesondere eine Querschnittsfläche von mehr als 2 Quadratmillimeter, insbesondere eine Querschnittsfläche von 2,5 Quadratmillimetern oder mehr als 2,5 Quadratmillimeter. Der Kontaktbereich, insbesondere die Schweißverbindung, zwischen dem Streifen und der Schicht ist beispielsweise 16 Quadratmillimeter groß. Insbesondere ist der Kontaktbereich beziehungsweise die Schweißverbindung größer als 10 Quadratmillimeter, insbesondere größer als 15 Quadratmillimeter. Im Unterschied zu einem Schweißen eines dünnen Drahts mit einem Querschnitt von beispielsweise weniger als 1 Quadratmillimeter auf einen kleinen Kontaktbereich für einen Stromfluss von beispielsweise kleiner als 1 Ampere ist das Schweißen des Streifens aus Kupfer weniger fehleranfällig und weist größere Prozesstoleranzen auf. Die thermisch gespritzte elektrisch leitfähige Schicht weist gemäß Ausführungsformen eine Dicke quer zur Längsrichtung auf, die der Dicke des Streifens im ersten Bereich entspricht oder dünner als der Streifen ist.

Der Streifen wird gemäß der Erfindung als elektrische und/oder mechanische Kontaktschnittstelle an die thermisch gespritzte elektrisch leitfähige Schicht verwendet. Dass der Streifen aus Kupfer ist, bedeutet beispielsweise, dass der Streifen aus reinem Kupfer gebildet sein kann. Dass der Streifen aus Kupfer ist, bedeutet beispielsweise auch, dass der Streifen überwiegend aus Kupfer besteht und noch weitere Beimengungen und/oder Verunreinigungen anderer Materialien aufweist. Beispielsweise weist der Streifen mindestens 80% Kupfer auf, beispielsweise mindestens 90% Kupfer, beispielsweise mindestens 95% Kupfer. Mittels des Streifens ist es möglich, eine Spannung an die thermisch gespritzte elektrisch leitfähige Schicht anzulegen. Beispielsweise ist die thermisch gespritzte elektrisch leitfähige Schicht eine Kontaktfläche eines Heizleiters. Der Heizleiter ist beispielsweise Teil eines mobilen Heizgeräts für ein Kraftfahrzeug. Das Heizgerät weist weitere Schichten auf, beispielsweise ein Substrat, darauf angeordnet einen Haftgrund, darauf angeordnet eine Isolierung, darauf angeordnet den Heizleiter. Der Heizleiter weist ein elektrisch leitfähiges Metall auf, insbesondere Nickel-Chrom (NiCr). Der Heizleiter ist gemäß Ausführungsformen durch ein thermisches Spritzverfahren hergestellt.

Die thermisch gespritzte leitfähige Schicht ist beispielsweise mittels eines thermischen Spritzens von Kupfer aufgebracht. Somit bietet das Verfahren eine Möglichkeit, den Streifen aus Kupfer auf die thermisch gespritzte Schicht, die Kupfer aufweist, aufzuschweißen. Somit wird insbesondere eine reine Kupfer/Kupfer-Verbindung ausgebildet. Es sind keine Zusatzstoffe notwendig. Bei einem herkömmlichen Lötverfahren sind dagegen Zusatzstoffe notwendig, die über die Lebensdauer zu Versprödung führen können. Somit ist durch die Schweißverbindung des Streifens und der thermisch gespritzten Schicht eine verlässliche Verbindung realisiert. Insbesondere ist der Streifen mit der thermisch gespritzten leitfähigen Schicht gasdicht und/oder stoffschlüssig verbunden.

Durch die stoffschlüssige Verbindung des Streifens auf der thermisch gespritzten Schicht werden eine Gasdichtheit und/oder eine Feuchtebeständigkeit der leitfähigen Schicht ermöglicht. Die Verwendung des Streifens aus Kupfer ermöglicht zudem eine Dauertemperaturbeständigkeit, insbesondere da Kupfer sehr gute Wärmeleiteigenschaften aufweist. Der Laserstrahl wird insbesondere nur eine relativ kurze Schweißzeit eingestrahlt, insbesondere im Bereich von einigen Millisekunden, insbesondere mehr als 1 Millisekunde und weniger als 10 Millisekunden, beispielsweise weniger als 5 Millisekunden. Somit wird verlässlich die Schweißverbindung ausgebildet. Dabei wird eine ungewünschte Schädigung weiterer Schichten des ersten Bauelements zuverlässig vermieden.

Gemäß weiteren Ausführungsformen wird der Laserstrahl so eingestrahlt, dass die geometrische Form der Schweißverbindung ringförmig ist. Gemäß weiteren Ausführungsformen wird der Laserstrahl so eingestrahlt, dass die geometrische Form der Schweißverbindung strichförmig ist. Gemäß weiteren Ausführungsformen wird der Laserstrahl so eingestrahlt, dass die geometrische Form der Schweißverbindung rechteckförmig ist. Gemäß weiteren Ausführungsformen wird der Laserstrahl so eingestrahlt, dass die geometrische Form der Schweißverbindung kreisförmig ausgebildet wird. Gemäß weiteren Ausführungsformen wird der Laserstrahl so eingestrahlt, dass die geometrische Form der Schweißverbindung punktförmig ausgebildet wird. Auch weitere Formen sind möglich, die eine verlässliche Verbindung zwischen den Streifen und der Schicht ermöglichen. Insbesondere sind verschiedene geometrische Formen der Schweißverbindung innerhalb einer Schweißverbindung möglich. Durch die Wahl der geometrischen Form, insbesondere als ringförmig, ist ein verlässliches Einkoppeln des Laserstrahls in den Streifen aus Kupfer möglich. Zudem wird ein ausreichend großer Bereich für die Schmelze der Schweißverbindung ermöglicht, die eine verlässliche elektrische und mechanische Kopplung der beiden Bauteile ermöglicht, insbesondere mittels einer stoffschlüssigen Verbindung.

Beispielsweise wird ein Laserstrahl im infraroten Bereich verwendet, beispielsweise mit einer Wellenlänge von 1064 nm. Gemäß weiteren Ausführungsformen wird ein Laser im grünen Bereich verwendet, beispielsweise mit einer Wellenlänge von 532 nm. Gemäß weiteren Ausführungsformen wird eine Lasermischform verwendet, beispielweise im infraroten und im grünen Bereich, die insbesondere die Wellenlängen von 1064 nm und 532 nm hat. Die Wellenlänge des verwendeten Laserstrahls wird insbesondere so vorgegeben, dass eine möglichst gute Einkopplung des Laserstrahls in Kupfer erreicht wird. Zudem wird auf eine geringe Fehleranfälligkeit beziehungsweise die Größe der Prozessfenster geachtet. Somit ist es möglich, möglichst wenige Defekte auszubilden. Der Laserstrahl wird beispielsweise von einem NdYAg-Laser erzeugt. Insbesondere wird der Laserstrahl durch einen Faserlaser erzeugt. Die Laserenergie wird, beispielsweise in Abhängigkeit der verwendeten Wellenlänge, so gewählt, dass nur der Streifen durch den Laserstrahl aufschmilzt. Die Schmelzzone breitet sich ausgehend von dem Streifen so aus, dass die thermisch gespritzte elektrisch leitfähige Schicht ebenfalls aufschmilzt. Die Materialien des Streifens und der Schicht vermischen sich und erstarren zu einer stoffschlüssigen Verbindung. Insbesondere aufgrund einer kleinen Schmelze und einer kurzen Schmelzdauer ist es möglich, zwei Elemente aus Kupfer miteinander zu verschweißen.

Laserparameter für den Laserstrahl umfassend die verwendete Wellenlänge, die Einstrahldauer und/oder die Leistung. Die Laserparameter umfassen alternativ oder zusätzlich die geometrische Form der Schweißverbindung beziehungsweise der dafür notwendigen Strahlführung des Laserstrahls. Weiterhin umfassen die Laserparameter die Art des Lasers, insbesondere wird ein Dauerstrichlaserstrahl oder ein gepulster Laserstrahl verwendet.

Gemäß Ausführungsformen wird der Laserstrahl zunächst mit ersten Laserparametern eingestrahlt und nachfolgend mit zweiten Laserparametern eingestrahlt, die zu den ersten Laserparametern unterschiedlich sind. Die ersten Laserparameter sind beispielsweise so vorgegeben, dass der Streifen vorgewärmt wird. Alternativ oder zusätzlich sind die ersten Laserparameter beispielsweise so vorgegeben, dass eine Oberfläche des Streifens aufgeraut wird. Alternativ oder zusätzlich werden die ersten Laserparameter so vorgegeben, dass die Oberfläche des Streifens gereinigt wird, beispielsweise so, dass ein Oxid entfernt wird, insbesondere eine Oxidschicht. Die zweiten Laserparameter sind so vorgegeben, dass das Material des Streifens aufschmilzt und die Schicht ebenfalls aufgeschmolzen wird, so dass sich die Schweißverbindung ausbildet.

Gemäß weiteren Ausführungsformen wird der Laserstrahl schräg eingestrahlt. Durch das schräge Einstrahlen des Laserstrahls mit einem Winkel von größer als 0° und kleiner als 90° zur Oberfläche des Streifens ist es möglich, den Laserstrahl gut in den Streifen einzukoppeln. Zudem ist es möglich, Beschädigungen aufgrund von ungewünschten Reflektionen an der Optik des Lasers zu vermeiden.

Die thermisch gespritzte Schicht ist beispielsweise mittels eines Atmosphärenplasmaspritzverfahrens hergestellt. Die Schicht ist insbesondere auf einen Schichtstapel aus zumindest einer Heizleiterschicht und einer Isolierschicht aufgebracht.

Gemäß weiteren Ausführungsformen wird die Dicke in einem Schweißbereich des ersten Bereichs des Streifens reduziert. Die Schweißverbindung wird in dem Schweißbereich ausgebildet. Insbesondere wird die Dicke in dem Schweißbereich auf eine vorgegebene zweite Dicke quer zur Längsrichtung reduziert. Die zweite Dicke ist in Abhängigkeit von einer Dicke der thermisch gespritzten elektrisch leitfähigen Schicht vorgegeben.

Somit ist es möglich, die Dicke des Schweißbereichs kleiner oder gleich der Dicke der thermisch gespritzten elektrisch leitfähigen Schicht auszubilden. Dadurch ist es möglich, den Energiebedarf des Laserstrahls zu reduzieren. Somit können Fehler vermieden werden, die durch zu tiefe Schweißungen entstehen. Die Schichten die unter der thermisch gespritzten elektrisch leitfähigen Schicht liegen werden somit beim Schweißen geschont. Außerhalb des Schweißbereichs bleibt die Dicke mehr als 0,1 Millimeter, um eine gute Wärmeabfuhr zu realisieren. Im Schweißbereich ist die Dicke geringer, um eine prozesssichere Verbindung des Streifens und der thermisch gespritzten elektrisch leitfähigen Schicht zu ermöglichen. Die Dicke des Schweißbereichs wird zur Dicke der thermisch gespritzten elektrisch leitfähigen Schicht insbesondere in ein optimales Verhältnis gebracht, um ein verlässliches Verschweißen zu ermöglichen.

Die Dicke des Schweißbereichs ist beispielsweise durch ein Prägeverfahren und/oder ein Walzverfahren und/oder ein Fräsverfahren und/oder ein Schleifverfahren und/oder ein Pressverfahren reduziert. Es kann auch ein anderes Verfahren verwendet werden, das zum Reduzieren der Dicke geeignet ist.

Gemäß eines weiteren Aspekts der Erfindung umfasst eine Vorrichtung die Merkmale des Anspruchs 10. Die Vorrichtung für ein Heizgerät für ein Kraftfahrzeug umfasst eine thermisch gespritzte elektrisch leitfähige Schicht. Die Vorrichtung weist einen Streifen aus Kupfer auf, der zumindest in einem ersten Bereich eine Dicke quer zur Längsrichtung von mehr als 0,1 mm aufweist. Gemäß weiteren Ausführungsformen weist der erste Bereich des Streifens eine Dicke quer zur Längsrichtung auf, wie oben in Zusammenhang mit dem Verfahren beschrieben. Die Vorrichtung weist eine Schweißverbindung auf, die die Schicht und den ersten Bereich des Streifens miteinander verbindet, um mittels des Streifens einen elektrischen und/oder mechanischen Kontakt an die Schicht zu bilden.

Die Vorrichtung ist ein Heizgerät für eine Standheizung und/oder eine Fahrheizung eines Kraftfahrzeugs. Das Heizgerät ist ein elektrisches Heizgerät, insbesondere ein Widerstandsheizgerät. Zur elektrischen Kontaktierung der Heizleiterschicht, die sich beim Anlegen einer elektrischen Spannung erwärmt, ist auf der Heizleiterschicht die thermisch gespritzte elektrisch leitfähige Schicht aufgebracht. Die thermisch gespritzte elektrisch leitfähige Schicht dient als Kontaktpad der Heizleiterschicht. Die thermisch gespritzte elektrisch leitfähige Schicht weist insbesondere thermisch gespritztes Kupfer auf. Der Streifen aus Kupfer ist auf das Kontaktpad aufgeschweißt und im Betrieb mit einer Spannungsquelle gekoppelt. Die Vorrichtung weist somit zur elektrischen Kontaktierung eine Schweißverbindung zwischen dem Streifen aus Kupfer und der thermisch gespritzten elektrisch leitfähigen Schicht auf, die insbesondere ebenfalls Kupfer aufweist.

Gemäß weiteren Ausführungsformen weist der Streifen einen zweiten Bereich außerhalb der Schweißverbindung auf. Der Streifen weist in dem zweiten Bereich eine Dicke quer zur Längsrichtung auf, die größer ist als die Dicke in dem ersten Bereich. Die Dicke des Streifens in den Bereichen ist insbesondere in Abhängigkeit von vorrangig zu erfüllenden Funktionen der Bereiche vorgegeben. In dem ersten Bereich ist die Dicke vorrangig im Hinblick auf eine gute Verschweißbarkeit vorgegeben. Im zweiten Bereich ist die Dicke beispielsweise vorrangig im Hinblick auf eine gute Stromtragfähigkeit und/oder Temperaturbeständigkeit vorgegeben.

Gemäß weiteren Ausführungsformen weist der Streifen in einem Schweißbereich des ersten Bereichs eine zweite Dicke auf, die kleiner ist als die Dicke. Die Schweißverbindung ist in dem Schweißbereich ausgebildet. Insbesondere ist die zweite Dicke in Abhängigkeit von einer Dicke der thermisch gespritzten elektrisch leitfähigen Schicht vorgegeben.

Somit ist die Dicke des Schweißbereichs kleiner oder gleich der Dicke der thermisch gespritzten elektrisch leitfähigen Schicht. Dadurch ist es möglich, während der Herstellung den Energiebedarf des Laserstrahls zu reduzieren. Somit können Fehler vermieden werden, die durch zu tiefe Schweißungen entstehen. Die Schichten die unter der thermisch gespritzten elektrisch leitfähigen Schicht liegen werden somit beim Schweißen geschont. Außerhalb des Schweißbereichs bleibt die Dicke mehr als 0,1 Millimeter, um eine gute Wärmeabfuhr zu realisieren. Im Schweißbereich ist die Dicke geringer, um eine prozesssichere Verbindung des Streifens und der thermisch gespritzten elektrisch leitfähigen Schicht zu ermöglichen. Die Dicke des Schweißbereichs wird zur Dicke der thermisch gespritzten elektrisch leitfähigen Schicht insbesondere in ein optimales Verhältnis gebracht, um ein verlässliches Verschweißen zu ermöglichen.

Gemäß Ausführungsformen ist eine Kontur der elektrisch leitfähigen Schicht in Projektion in einer Stapelrichtung des Schichtstapels vorgegeben, um einen Hitzestau an der elektrisch leitfähigen Schicht zu vermeiden. Die Kontur ist vorgegeben durch mindestens eines aus:
- einer vorgegebenen Breite einer Vorderseite der elektrisch leitfähigen Schicht, die einem Mittelbereich der Heizleiterschicht zugewandt ist,
- einem vorgegebenen Abstand zu einer Trennfuge der Heizleiterschicht, und
- einer vorgegebenen Krümmung der Kontur.

Gemäß weiteren Ausführungsformen ist in der Projektion in der Stapelrichtung entlang der Vorderseite die vorgegebene Krümmung mittels zwei zueinander unterschiedlicher vorgegebener Radien für die Vorderseite vorgegeben.

Gemäß weiteren Ausführungsformen weist die Vorderseite in der Projektion in der Stapelrichtung einen gerade verlaufenden Abschnitt auf.

Gemäß weiteren Ausführungsformen weist die Vorderseite in der Projektion in der Stapelrichtung einen konkaven und einen konvexen Abschnitt auf.

Gemäß weiteren Ausführungsformen verjüngt sich in der Projektion in der Stapelrichtung eine Breite der elektrisch leifähigen Schicht ausgehend von der Breite der Vorderseite zumindest in einem Teilbereich der elektrisch leitfähigen Schicht.

Weitere Vorteile, Merkmale und Weiterbildungen ergeben sich aus den nachfolgenden, in Verbindung mit den Figuren erläuterten Beispielen. Gleiche, gleichartige und gleich wirkende Elemente können dabei mit den gleichen Bezugszeichen versehen sein. Die dargestellten Elemente und ihre Größenverhältnisse zueinander sind grundsätzlich nicht als maßstabsgerecht anzusehen.

Es zeigen:
- Figur 1: eine schematische Aufsicht auf eine Vorrichtung gemäß Ausführungsformen,
- Figur 2: eine schematische Darstellung einer Schnittansicht der Vorrichtung gemäß Ausführungsformen,
- Figur 3: eine schematische Darstellung einer Schnittansicht der Vorrichtung gemäß Ausführungsformen,
- Figur 4: eine schematische Darstellung einer Schnittansicht der Vorrichtung gemäß Ausführungsformen,
- Figur 5: eine schematische Aufsicht auf eine Vorrichtung gemäß Ausführungsformen,
- Figur 6: eine schematische Darstellung einer Schnittansicht der Vorrichtung gemäß Ausführungsformen, und
- Figur 7: eine schematische Darstellung einer Schnittansicht der Vorrichtung gemäß Ausführungsformen.

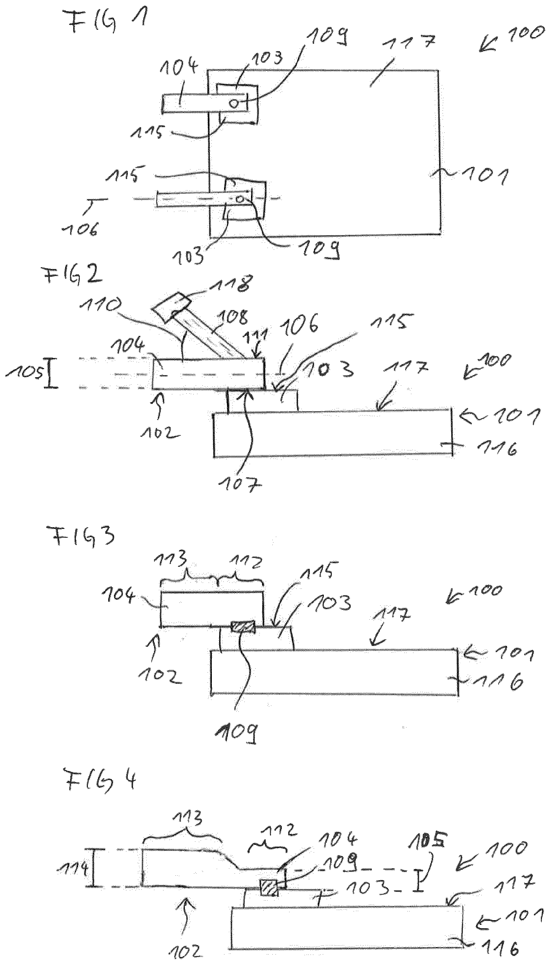

Figur 1 zeigt eine Aufsicht auf eine Vorrichtung 100. Die Vorrichtung 100 ist insbesondere Teil eines Heizgeräts für ein Kraftfahrzeug. Das Heizgerät ist ein elektrisches Heizgerät, das Wärme erzeugt, wenn im Betrieb eine Spannung angelegt wird.

Die Vorrichtung 100 weist ein erstes Bauelement 101 auf. Das erste Bauelement 101 weist einen Schichtstapel 116 auf. Der Schichtstapel 116 weist gemäß der Erfindung eine Heizleiterschicht auf einer Isolationsschicht auf. Der Schichtstapel kann weitere Schichten wie beispielsweise Zwischenschichten zwischen der Heizleiterschicht und der Isolationsschicht aufweisen.

Auf einem Teil einer Oberfläche 117 der Heizleiterschicht ist eine elektrisch leitfähige Schicht 103 aufgebracht. Die elektrisch leitfähige Schicht ist mittels eines thermischen Spritzprozesses aufgebracht, insbesondere mittels eines atmosphärischen Plasmaspritzens. Insbesondere wird ein Lichtbogen verwendet und ein Inertgas durch den Lichtbogen geleitet. Beispielsweise wird Druckluft verwendet. Kupferpulver wird eingeleitet, das durch die hohe Plasmatemperatur aufgeschmolzen wird. Der Plasmastrom reißt die Pulverteilchen mit und schleudert sie auf den Schichtstapel 116. Die elektrisch leitfähige Schicht 103 weist beispielsweise eine Dicke 121 quer zu einer Längsrichtung 106 von größer als 250 µm und kleiner als 450 µm auf, beispielsweise 300 µm.

Die elektrisch leitfähige Schicht 103 ist aus Kupfer gebildet oder weist Kupfer auf. Beispielsweise weist die elektrisch leitfähige Schicht 99 % Kupfer auf. Das Kupfer ist mittels des thermischen Spritzprozesses auf den Schichtstapel 116 aufgebracht, so dass eine elektrische Verbindung zwischen der elektrisch leitfähigen Schicht 103 und der Heizleiterschicht besteht. Die elektrisch leitfähige Schicht 103 bildet Kontaktpads zur elektrischen und/oder mechanischen Kontaktierung des Schichtstapels 116.

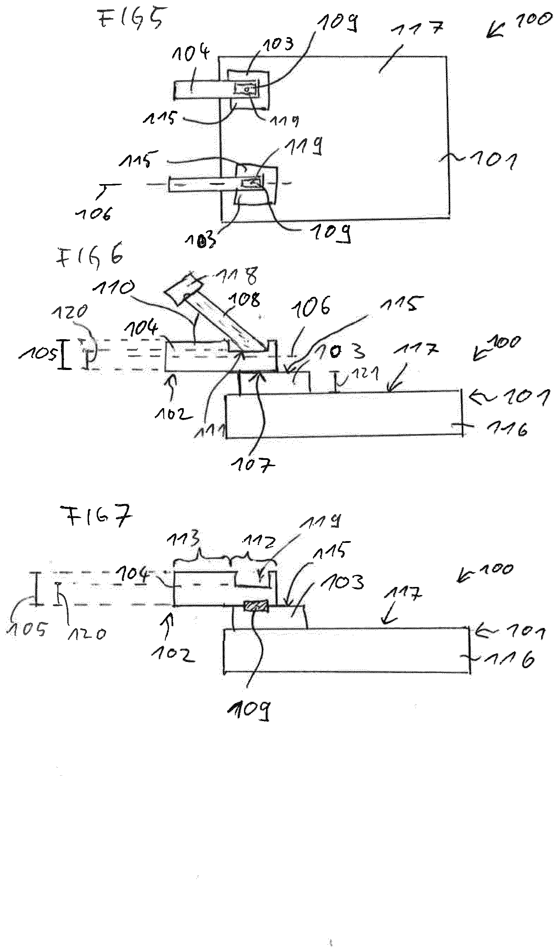

Die Kontur der elektrisch leitfähigen Schicht 103, insbesondere der Umriss in Aufsicht der Figuren 1 und 5, ist gemäß Ausführungsbeispielen so vorgegeben, das im Betrieb Strom verlässlich in die Heizleiterschicht eingeleitet werden kann. Die Kontur der elektrisch leitfähigen Schicht 103 ist so vorgegeben, dass ein gleichmäßiger Stromtransport und damit eine gleichmäßige Wärmeverteilung realisiert sind. Somit ist es möglich, Hitzestaus (englisch: hot spots) zu vermeiden. Gemäß Ausführungsformen ist die Breite der vorderen Kante beziehungsweise der Frontfläche der elektrisch leitfähigen Schicht 103 so vorgegeben, dass ein gleichmäßiger Stromtransport und damit eine gleichmäßige Wärmeverteilung realisiert sind. Die Frontfläche beziehungsweise vordere Kante ist einem Mittelbereich der Oberfläche 117 zugewandt. Alternativ oder zusätzlich werden die Ecken der elektrisch leitfähigen Schicht 103 vorgegeben abgerundet, um einen gleichmäßigen Stromtransport und damit eine gleichmäßige Wärmeverteilung zu realisieren. Alternativ oder zusätzlich ist ein Abstand einer benachbarten Trennfuge der Heizleiterschicht so vorgegeben, dass ein gleichmäßiger Stromtransport und damit eine gleichmäßige Wärmeverteilung realisiert sind. Die Trennfuge dient insbesondere dazu, die Heizleiterschicht in Leiterbahnen aufzutrennen. Durch die vorgegebene Kontur des Kontaktpads, das von der elektrisch leitfähigen Schicht 103 gebildet ist, ist es möglich, die Temperaturen an dem Kontaktpad im Betrieb trotz eines hohen Stromflusses so gering zu halten, dass ein verlässlicher Betrieb realisiert ist.

An der elektrisch leitfähigen Schicht 103 ist ein zweites Bauelement 102 stoffschlüssig verbunden. Das zweite Bauelement 102 weist einen Streifen 104 aus Kupfer auf. Der Streifen 104 ist beispielsweise aus einer Kupferlegierung gebildet. Der Streifen 104 aus Kupfer erstreckt sich länglich ausgedehnt entlang der Längsrichtung 106. Die Längsrichtung 106 ist beispielsweise diejenige Raumrichtung, entlang der der Streifen seine größte Ausdehnung aufweist.

Im Betrieb sind zwei Streifen 104 und zwei Schichten 103 vorgesehen. Mittels den beiden Streifen 104 ist die Vorrichtung 100 mit einer Strom/Spannungsquelle verbindbar. Die beiden in Figur 1 dargestellten elektrisch leitfähigen Schichten und die beiden Streifen 104 bilden im Betrieb beispielsweise den Plus- und Minuspol für die elektrische Spannung aus.

Der Streifen 104 ist jeweils mittels einer Schweißverbindung 109 mit der elektrisch leitfähigen Schicht 103 verbunden. Die Schweißverbindung 109 bildet eine mechanische und elektrische Verbindung zwischen dem Streifen 104 und der elektrisch leitfähigen Schicht 103. Die elektrisch leitfähige Schicht weist eine größere Grundfläche auf als der Bereich des Streifens 104, der mit der elektrisch leitfähigen Schicht 103 in Kontakt ist. Somit wird im Betrieb die Temperatur der elektrisch leitfähigen Schicht 103 reduziert im Vergleich zu einer Kontaktschicht, die eine Größe aufweist, die im Wesentlichen dem Bereich des Streifens 104 entspricht, der mit der elektrisch leitfähigen Schicht in Kontakt ist.

In Figur 1 ist die Schweißverbindung 109 kreisförmig dargestellt. Gemäß weiteren Ausführungsformen weist die Schweißverbindung eine andere geometrische Form auf, beispielsweise strichförmig, rechteckförmig und/oder kreis/punktförmig. Auch eine Mischung verschiedener geometrischer Formen ist möglich. Insbesondere ist gemäß Ausführungsformen nicht nur ein einziger Kreis je Schweißverbindung 109 vorgesehen, wie in Figur 1 dargestellt, sondern zwei oder mehr voneinander beabstandete und/oder überlappende Schweißverbindungen. Beispielsweise ist eine Überlapp-Kehlnaht als Nahtanordnung vorgesehen.

Figur 2 zeigt eine Schnittansicht der Vorrichtung 100 während der Herstellung. Auf die Oberfläche 117 des Schichtstapels 116 ist die elektrisch leitfähige Schicht 103 aus thermisch aufgespritztem Kupfer ausgebildet. Auf eine der Oberfläche 117 abgewandten Oberfläche 115 der elektrisch leitfähigen Schicht 103 wird der Streifen 104 aufgelegt. Der Streifen 104 und die elektrisch leitfähige Schicht 103 haben somit in einem ersten Bereich 112 (Figur 3) einen gemeinsamen Kontaktbereich 107. In dem gemeinsamen Kontaktbereich 107 berühren sich der Streifen 104 und die elektrisch leitfähige Schicht 103. Der Streifen 104 und die elektrisch leitfähige Schicht 103 werden möglichst spaltfrei aufeinander gelegt. Im Kontaktbereich 107 sind das Kupfer des Streifens 104 und das Kupfer der elektrisch leitfähigen Schicht 103 in direktem Kontakt miteinander.

Der Streifen 104 weist eine Dicke 105 quer zur Längsrichtung 106 auf. Die Dicke 105 wird so groß gewählt, dass im Betrieb ein ausreichend großer Stromfluss möglich ist. Beispielsweise wird im Betrieb eine Spannung von 100 V an die Streifen 104 angelegt und es fließt ein ausreichend großer Strom, um eine für ein Kraftfahrzeug ausreichend große Heizleistung der Vorrichtung 100 zu ermöglichen. Die Dicke 105 ist insbesondere größer als 0,1 mm und kleiner als 0,6 mm. Gemäß weiteren Ausführungsformen ist die Dicke 105 größer als 0,2 mm. Gemäß weiteren Ausführungsformen ist die Dicke 105 größer als 0,3 mm. Insbesondere ist die Dicke 105 zwischen 0,2 mm und 0,3 mm. Gemäß weiteren Ausführungsformen ist die Dicke 105 zwischen 0,4 mm und 0,6 mm. Gemäß weiteren Ausführungsformen ist die Dicke größer als 0,5 mm, insbesondere größer als 1 mm. Die Dicke 105 ist kleiner als 5 mm, insbesondere kleiner als 2 mm. Die Dicke 105 wird ausreichend dick gewählt, um eine ausreichend hohe Stromtragfähigkeit zu realisieren. Beispielsweise wird die Dicke 105 so gewählt, dass eine Stromtragfähigkeit von 25 A realisiert ist.

Ein Laserstrahl 108 wird mittels eines Lasers 118 auf eine Seite 111 des Streifens 104 eingestrahlt. Die Seite 111 ist an einer Oberfläche, die der Schicht 103 abgewandt ist. Der Laserstrahl 108 wird insbesondere unter einem Winkel 110 eingestrahlt. Der Winkel 110 ist größer als 0°, insbesondere größer als 20°. Der Winkel 100 ist kleiner als 90°, insbesondere kleiner als 80°. Der Winkel 110 wird so vorgegeben, dass der Laserstrahl 108 möglichst gut in den Streifen 104 einkoppelt. Der Winkel 110 wird alternativ oder zusätzlich so vorgegeben, dass Beschädigungen am Laser aufgrund von ungewünschten Reflektionen an der Oberfläche 111 vermieden werden.

Der Laser 118 ist gemäß Ausführungsformen ein Faserlaser. Insbesondere ist der Laser 118 ein Nd:YAG-Laser (Neodymdotierter Yttrium-Aluminium-Granat-Laser). Gemäß weiteren Ausführungsformen wird ein anderer Laser verwendet.

Insbesondere ist der Laser 118 ausgebildet, die Laserstrahlen 108 mit einer Wellenlänge von 532 nm zu erzeugen. Gemäß weiteren Ausführungsformen wird alternativ oder zusätzlich der Laserstrahl 108 mit einer Wellenlänge von 1064 nm erzeugt. Beispielsweise wird sowohl ein Laserstrahl mit 532 nm Wellenlänge als auch ein Laserstrahl mit 1064 nm Wellenlänge ausgestrahlt. Der Laserstrahl mit 532 nm koppelt besonders gut in den Streifen 104 ein. Der Laserstrahl mit 1064 nm weist einen hohen Energieeintrag in den Streifen 104 auf. Die Laserleistung des Laserstrahls 108 wird so vorgegeben, dass der Streifen 104 bereichsweise aufschmilzt. Beispielsweise wird eine Laserenergie von 400 W gewählt. Die Laserenergie wird an der Oberfläche 111 des Streifens 104 beziehungsweise im Inneren des Streifens 104 absorbiert und wird so hoch gewählt, dass das Material des Streifens 104 im Bereich 112 zumindest teilweise aufschmilzt. Die Schmelzzone breitet sich in Richtung der Schicht 103 soweit aus, dass auch die elektrisch leitfähige Schicht 103 aufgeschmolzen wird. Die Schicht 103 wird zumindest in einem Bereich aufgeschmolzen, der unmittelbar an die Oberfläche 114 angrenzt. Die Materialien des Streifens 104 und der Schicht 103 vermischen sich in der Schmelze. Nachfolgend erstarrt die Schmelze zu der stoffschlüssigen Schweißverbindung 109 (Figur 3) .

Gemäß weiteren Ausführungsformen wird die Oberfläche 111 vorbehandelt, bevor der Laserstrahl 108 zum Verschweißen eingestrahlt wird. Die Vorbehandlung dient insbesondere zur Reinigung und/oder Aufrauung der Oberfläche 111. Durch die Reinigung wird beispielsweise eine Oxidschicht von der Oberfläche 111 entfernt. Durch das Aufrauen der Oberfläche wird die Einkopplung des Laserstrahls 108 in den Streifen 104 verbessert. Durch das Aufrauen wird der Anteil des Laserstrahls 108, der an der Oberfläche 111 reflektiert wird, verringert. Der Anteil des Laserstrahls 108, der ins Innere des Streifens 104 eindringt beziehungsweise der von dem Streifen 104 absorbiert wird, wird erhöht. Mittels des Aufrauens ist es möglich, den Reflexionsgrad der Oberfläche 111 auf einen gewünschten Wert einzustellen. Insbesondere wird der Reflexionsgrad im Vergleich zu einer nicht aufgerauten Oberfläche so reduziert, dass ein höherer Wärmeeintrag beim Schweißen ermöglicht wird. Somit ist das Eikoppelverhalten des Laserstrahls 108 verbessert. Durch die aufgeraute Oberfläche 111 wird der Anteil der Energie des Laserstrahls 108 erhöht, der von dem Streifen 104 absorbiert wird.

Die Vorbehandlung der Oberfläche 111 erfolgt insbesondere unter Verwendung des Laserstrahls 108. Zur Vorbehandlung werden die Laserparameter für den Laserstrahl 108 so eingestellt, dass der Laserstrahl 108 das Material des Streifens 104 nicht aufschmilzt, sondern lediglich die Oberfläche 111 aufgeraut wird. Beispielsweise wird ein gepulster Laser verwendet. Zudem wird beispielsweise eine kreisförmige Strahlführung zur Vorbehandlung verwendet. Alternativ oder zusätzlich erfolgt die Vorbehandlung mechanisch, beispielsweise durch ein Bürsten. Alternativ oder zusätzlich erfolgt die Vorbehandlung chemisch, beispielsweise durch ein Anätzen der Oberfläche 111.

Gemäß weiteren Ausführungsformen wird zur Vorbehandlung vor dem Verschweißen der Streifen 104 zumindest im Bereich 112 alternativ oder zusätzlich vorgewärmt. Zum Vorwärmen wird insbesondere der Laserstrahl 108 mit entsprechend vorgegebenen Laserparametern verwendet. Durch das Vorwärmen wird beispielsweise das Einkoppeln des Laserstrahls 108 in den Streifen 104 beim Verschweißen weiter verbessert.

Zum Verschweißen werden andere Laserparameter als zur Vorbehandlung für den Laserstrahl 108 vorgegeben. Beispielsweise wird zum Verschweißen ein Dauerstrichlaserstrahl 108 verwendet. Beispielsweise wird eine Tophat (Zylinderform) und/oder Rechteckfaser als Strahlqualität verwendet. Die Strahlqualität beziehungsweise das Strahlprofil wird so vorgegeben, dass das Material des Streifens 104 aufgeschmolzen wird, insbesondere ohne dass ein Materialabtrag beispielsweise durch Verbrennen erfolgt. Insbesondere wird eine vergleichsweise kleine Schmelzzone ausgebildet und vergleichsweise kurze Schmelzdauern vorgegeben. Somit ist ein Verschweißen des Streifens 104 und der Schicht 103 möglich, die jeweils Kupfer aufweisen. Auf Zusatzstoffe kann dabei verzichtet werden. Beispielsweise wird die Anzahl und die Form der Schweißverbindungen 109 so gewählt, dass sie einem analogen Aderquerschnitt von 2,4 mm² entsprechen. Damit ist es möglich, den Streifen 104 aus Kupfer auf der thermischen Kupferspritzschicht 103 aufzubringen. Eine Stromtragfähigkeit von 25 A ist dabei gewährleistet.

Figur 4 zeigt die Vorrichtung 100 gemäß weiteren Ausführungsformen. Die Vorrichtung 100 entspricht im Wesentlichen den Ausführungsbeispielen, wie in Verbindung mit Figuren 1 bis 3 erläutert. Im Unterschied weist der Streifen 104 in einem zweiten Bereich 113 eine zweite Dicke 114 auf. Die zweite Dicke 114 ist größer als die Dicke 105. Der zweite Bereich 113 ist unterschiedlich zum ersten Bereich 112 und außerhalb des Kontaktbereichs 107 angeordnet. Die Dicke in dem Bereich 112, in dem der Streifen 104 mit der Schicht 103 verschweißt wird, ist geringer als die Dicke 114 in dem Bereich 113, der der Strom/Spannungsquelle im Betrieb zugewandt ist. Somit ist es möglich, in dem Bereich 112 eine möglichst gute Schweißverbindung 109 zu realisieren. Gleichzeitig wird in dem Bereich 113 eine möglichst gute Stromtragfähigkeit realisiert.

Figuren 4 bis 7 zeigen die Vorrichtung 100 gemäß weiteren Ausführungsformen. Die Vorrichtung 100 entspricht im Wesentlichen den Ausführungsbeispielen, wie in Verbindung mit Figuren 1 bis 3 erläutert. Im Unterschied weist der Streifen 104 in dem ersten Bereich 112 einen Schweißbereich 119 auf. Der Schweißbereich 119 weist eine Dicke 120 quer zur Längsrichtung 106 auf. Die Dicke 120 ist geringer als die Dicke 105. Außerhalb des Schweißbereichs 119 weist der Streifen 104 im ersten Bereich 112 die Dicke 105 auf, die größer 0,1 Millimeter ist.

Die Dicke 105 wird beispielsweise durch ein Prägeverfahren und/oder ein Walzverfahren und/oder ein Fräsverfahren und/oder ein Schleifverfahren und/oder ein Pressverfahren auf die Dicke 120 reduziert. Es kann auch ein anderes Verfahren verwendet werden, das zum Reduzieren der Dicke geeignet ist.

Die Dicke 105 wird so gewählt, dass eine gute Stromtragfähigkeit und eine gute Wärmeleitfähigkeit realisiert sind. Der Bereich der Vorrichtung 100 der Schicht 103 wird im Betrieb nicht beheizt. Der Bereich der Vorrichtung 100 der Schicht 103 wird insbesondere durch das unter diesem Bereich fließende Medium gekühlt. Durch diese Kühlung ist in diesem Bereich für die auftretenden Lastströme die geringere Dicke 120 ausreichend. In den anderen Bereichen, insbesondere außerhalb des Schweißbereichs 119 ist die Dicke 105 größer als im Schweißbereich 119, um für die auftretenden Lastströme eine ausreichende Wärmeabfuhr zu gewährleisten.

Die Schweißverbindung 109 wird somit an dem Schweißbereich 119 mit der geringeren Dicke 120 ausgebildet. Dadurch ist es möglich, den Laserstrahl 108 mit einem geringeren Energiebedarf zu betreiben. Zu tiefe Schweißungen, die die Schicht 103 beschädigen, können somit vermieden werden. Dadurch ist es möglich, bei der Herstellung die Anzahl der Ausschussteile zu reduzieren.

Die Dicke 120 ist insbesondere in Abhängigkeit der Dicke 121 der Schicht 103 quer zur Längsrichtung 106 vorgegeben. Je größer die Dicke 121 ist, desto größer wird beispielsweise der maximale Wert für die Dicke 120 vorgegeben. Je kleiner die Dicke 121 ist, desto kleiner wird beispielsweise der maximale Wert für die Dicke 120 vorgegeben. Insbesondere ist die Dicke 120 kleiner oder gleich der Dicke 121 der Schicht 103. Die Dicke 121 ist beispielweise größer als 50 Mikrometer und kleiner als 450 Mikrometer, insbesondere 200 Mikrometer oder 300 Mikrometer.

Der Streifen 104 weist somit mindestens zwei unterschiedliche Dicken 105 und 120 auf. Der Streifen 104 weist dadurch eine ausreichende Wärmeabfuhr auf und ist verlässlich verschweißbar.

Auch eine Kombination mit dem Ausführungsbeispiel der Figur 4 ist möglich, in dem der zweite Bereich 113 die größere Dicke 114 hat als der erste Bereich 112 und der erste Bereich 112 den Schweißbereich aufweist, der die reduzierte Dicke 120 aufweist.

Der Streifen 104 aus Kupfer gemäß den Ausführungsbeispielen der Figuren 1 bis 7 weist eine ausreichend hohe Stromtragfähigkeit auf, um für ein Heizgerät in einem Kraftfahrzeug als Kontakt verwendet zu werden. Durch die Schweißverbindung des Streifens 104 mit der Schicht 103 ist eine gasdichte und feuchtebeständige stoffschlüssige Verbindung gegeben. Dabei wird das poröse Material der Schicht 103 durch das Vollmaterial des Streifens 104 und/oder die stoffschlüssige Verbindung 109 bedeckt. Zum Ausbilden der Schweißverbindung 109 sind kurze Schweißzeiten im Bereich von Millisekunden möglich. Somit ist eine Verbindung des Streifens 104 mit der Schicht 103 verlässlich möglich und eine ungewünschte Beeinflussung des Schichtstapels 101 beispielsweise eine Schädigung wird vermieden. Durch die Schweißverbindung 109 ist eine verlässliche Verbindung zwischen den Streifen 104 und der Schicht 103 über die Lebensdauer der Vorrichtung ermöglicht.

## Patentansprüche

1. Verfahren zum Bearbeiten eines ersten Bauelements (101) und eines zweiten Bauelements (102) für ein Heizgerät für ein Kraftfahrzeug, umfassend:
- Bereitstellen des ersten Bauelements (101), das eine thermisch gespritzte elektrisch leitfähige Schicht (103) und einen zumindest eine Heizleiterschicht und eine Isolierschicht aufweisenden Schichtstapel (116) umfasst, wobei die elektrisch leitfähige Schicht (103) als Kontaktpad zur elektrischen und/oder mechanischen Kontaktierung einer Heizleiterschicht des Schichtstapels (116) dient,
- Bereitstellen des zweiten Bauelements (102), das einen länglich ausgedehnten Streifen (104) aus Kupfer aufweist, der zumindest in einem ersten Bereich (112) eine Dicke (105) quer zur Längsrichtung (106) von mehr als 0,1 Millimeter aufweist,
- Anordnen des Streifens (104) und der Schicht (103) aufeinander, so dass der erste Bereich (112) des Streifens (104) und die Schicht (103) einen gemeinsamen Kontaktbereich (107) miteinander aufweisen,
- Einstrahlen eines Laserstrahls (108) auf den Kontaktbereich (107) und dadurch:
- Ausbilden einer Schweißverbindung (109), die den Streifen (104) und die Schicht (103) miteinander verbindet.

2. Verfahren nach Anspruch 1, bei dem der Laserstrahl (108) so eingestrahlt wird, dass die geometrische Form der Schweißverbindung (109) Ring-förmig, Strich-förmig, Rechteckförmig oder Kreis-förmig ausgebildet wird.

3. Verfahren nach Anspruch 1 oder 2, bei dem der Laserstrahl (108) mit ersten Laserparametern eingestrahlt wird und nachfolgend mit zweiten Laserparametern eingestrahlt wird, die zu den ersten Laserparametern unterschiedlich sind und die so vorgegeben sind, dass die Schweißverbindung (109) ausgebildet wird.

4. Verfahren nach einem der Ansprüche 1 bis 3, bei dem der Laserstrahl (108) schräg eingestrahlt wird.

5. Verfahren nach einem der Ansprüche 1 bis 4, bei dem der Laserstrahl (108) auf einer der Schicht (103) abgewandten Seite (111) auf den Streifen (104) eingestrahlt wird.

6. Verfahren nach Anspruch 5, bei dem das Bereitstellen des zweiten Bauelements (102) umfasst:
- Aufrauen der der Schicht (103) abgewandten Seite (111) des Streifens (104) mittels des Laserstrahls (108) und/oder chemisch und/oder mechanisch.

7. Verfahren nach einem der Ansprüche 1 bis 6, bei dem das Bereitstellen des ersten Bauelements (101) umfasst:
- thermisches Spritzen von Kupfer zum Ausbilden der elektrisch leitfähigen Schicht (103).

8. Verfahren nach einem der Ansprüche 1 bis 7, bei dem das Bereitstellen des zweiten Bauelements (102) umfasst:
- Reduzieren der Dicke (105) in einem Schweißbereich (119) des ersten Bereichs (112) des Streifens (104), und
- Ausbilden der Schweißverbindung (109) in dem Schweißbereich (119) .

9. Verfahren nach Anspruch 8, umfassend:
- Reduzieren der Dicke (105) in dem Schweißbereich (119) auf eine vorgegebene zweite Dicke (120) quer zur Längsrichtung (106), wobei die zweite Dicke (120) in Abhängigkeit von einer Dicke (121) der thermisch gespritzten elektrisch leitfähigen Schicht (103) vorgegeben ist und die zweite Dicke (120) kleiner ist als die Dicke (121) der thermisch gespritzten elektrisch leitfähigen Schicht (103).

10. Vorrichtung für ein Heizgerät für ein Kraftfahrzeug, umfassend:
- einen Schichtstapel (116) mit einer Heizleiterschicht und einer Isolierschicht,
- eine thermisch gespritzte elektrisch leitfähige Schicht (103), die als Kontaktpad zur elektrischen und/oder mechanischen Kontaktierung der Heizleiterschicht dient,
- einen Streifen (104) aus Kupfer, der zumindest in einem ersten Bereich (112) eine Dicke (105) quer zur Längsrichtung (106) von mehr als 0,1 Millimeter aufweist,
- eine Laserschweißverbindung (109), die die Schicht (103) und den ersten Bereich (112) des Streifens (104) miteinander verbindet, um mittels des Streifens (104) einen elektrischen und/oder mechanischen Kontakt an die Schicht (103) zu bilden.

11. Vorrichtung nach Anspruch 10, bei der der Streifen (104) einen zweiten Bereich (113) außerhalb der Schweißverbindung (109) aufweist, wobei der Streifen (104) in dem zweiten Bereich (113) eine Dicke (114) quer zur Längsrichtung (106) aufweist, die größer ist als die Dicke (105) in dem ersten Bereich (112).

12. Vorrichtung nach Anspruch 10 oder 11, bei der die thermisch gespritzte elektrisch leitfähige Schicht (103) Kupfer aufweist.

13. Vorrichtung nach einem der Ansprüche 10 bis 12, bei der:
- der Streifen (104) in einem Schweißbereich (119) des ersten Bereichs (112) eine zweite Dicke (120) aufweist, die kleiner als die Dicke (105) ist, und
- die Schweißverbindung (109) in dem Schweißbereich (119) ausgebildet ist.

14. Vorrichtung nach Anspruch 13, bei der:
- die zweite Dicke (120) in Abhängigkeit von einer Dicke (121) der thermisch gespritzten elektrisch leitfähigen Schicht (103) vorgegeben ist, und
- und die zweite Dicke (120) kleiner als die Dicke (121) der thermisch gespritzten elektrisch leitfähigen Schicht (103) ist.

15. Vorrichtung nach einem der Ansprüche 10 bis 14, umfassend eine Heizleiterschicht (102) auf die elektrisch leitfähige Schicht (103) angeordnet ist, wobei
- eine Kontur der elektrisch leitfähigen Schicht (103) vorgegeben ist, um einen Hitzestau an der elektrisch leitfähigen Schicht (103) zu vermeiden, durch mindestens eines aus:
- einer vorgegebenen Breite einer Vorderseite der elektrisch leitfähigen Schicht (103), die einem Mittelbereich (114) der Heizleiterschicht zugewandt ist,
- einem vorgegebenen Abstand zu einer Trennfuge der Heizleiterschicht, und
- einer vorgegebenen Krümmung der Kontur.

## Claims

1. Method for working a first component (101) and a second component (102) for a heater for a motor vehicle, comprising:
- providing the first component (101), which comprises a thermally sprayed electrically conductive layer (103) and a stack of layers (116) having at least a heating conductor layer and an insulating layer, wherein the electrically conductive layer (103) serves as a contact pad for the electrical and/or mechanical contacting of a heating conductor layer of the stack of layers (116),
- providing the second component (102), which has a longitudinally extended strip (104) of copper, which at least in a first region (112) has a thickness (105) transversely to the longitudinal direction (106) of more than 0.1 millimeter,
- arranging the strip (104) and the layer (103) one on top of the other, so that the first region (112) of the strip (104) and the layer (103) have a contact region (107) in common with one another,
- emitting a laser beam (108) onto the contact region (107) and thereby:
- forming a welded connection (109), which connects the strip (104) and the layer (103) to one another.

2. Method according to Claim 1, in which the laser beam (108) is emitted such that the geometrical form of the welded connection (109) is formed as annular, linear, rectangular or circular.

3. Method according to Claim 1 or 2, in which the laser beam (108) is emitted with first laser parameters and is subsequently emitted with second laser parameters that are different from the first laser parameters and are prescribed such that the welded connection (109) is formed.

4. Method according to one of Claims 1 to 3, in which the laser beam (108) is emitted obliquely.

5. Method according to one of Claims 1 to 4, in which the laser beam (108) is emitted onto the strip (104) on a side (111) that is facing away from the layer (103).

6. Method according to Claim 5, in which the provision of the second component (102) comprises:
- roughening the side (111) of the strip (104) that is facing away from the layer (103) by means of the laser beam (108) and/or chemically and/or mechanically.

7. Method according to one of Claims 1 to 6, in which the provision of the first component (101) comprises:
- thermally spraying copper to form the electrically conductive layer (103).

8. Method according to one of Claims 1 to 7, in which the provision of the second component (102) comprises:
- reducing the thickness (105) in a welding region (119) of the first region (112) of the strip (104), and
- forming the welded connection (109) in the welding region (119).

9. Method according to Claim 8, comprising:
- reducing the thickness (105) in the welding region (119) to a prescribed second thickness (120) transversely to the longitudinal direction (106), the second thickness (120) being prescribed in dependence on a thickness (121) of the thermally sprayed electrically conductive layer (103) and the second thickness (120) being less than the thickness (121) of the thermally sprayed electrically conductive layer (103).

10. Device for a heater for a motor vehicle, comprising:
- a stack of layers (116) comprising a heating conductor layer and an insulating layer,
- a thermally sprayed electrically conductive layer (103) which serves as a contact pad for the electrical and/or mechanical contacting of the heating conductor layer,
- a strip (104) of copper, which at least in a first region (112) has a thickness (105) transversely to the longitudinal direction (106) of more than 0.1 millimeter,
- a laser welded connection (109), which connects the layer (103) and the first region (112) of the strip (104) to one another in order to form by means of the strip (104) an electrical and/or mechanical contact with respect to the layer (103).

11. Device according to Claim 10, in which the strip (104) has a second region (113) outside the welded connection (109), the strip (104) having in the second region (113) a thickness (114) transversely to the longitudinal direction (106) that is greater than the thickness (105) in the first region (112).

12. Device according to Claim 10 or 11, in which the thermally sprayed electrically conductive layer (103) comprises copper.

13. Device according to one of Claims 10 to 12, in which:
- the strip (104) has in a welding region (119) of the first region (112) a second thickness (120) that is less than the thickness (105), and
- the welded connection (109) is formed in the welding region (119).

14. Device according to Claim 13, in which:
- the second thickness (120) is prescribed in dependence on a thickness (121) of the thermally sprayed electrically conductive layer (103), and
- the second thickness (120) is less than the thickness (121) of the thermally sprayed electrically conductive layer (103).

15. Device according to one of Claims 10 to 14, comprising
a heating conductor layer (102) is arranged on the electrically conductive layer (103),
- a contour of the electrically conductive layer (103) being prescribed to avoid a buildup of heat at the electrically conductive layer (103), by at least one of the following:
- a prescribed width of a front side of the electrically conductive layer (103) that is facing a middle region (114) of the heating conductor layer,
- a prescribed distance from an isolation groove of the heating conductor layer, and
- a prescribed curvature of the contour.

## Revendications

1. Procédé d'usinage d'un premier élément structural (101) et d'un deuxième élément structural (102) pour un appareil de chauffage pour un véhicule automobile, comprenant :
- la fourniture du premier élément structural (101), qui comporte une couche électriquement conductrice (103) pulvérisée thermiquement et un empilement de couches (116) qui présente au moins une couche de conducteur chauffant et une couche isolante, la couche électriquement conductrice (103) servant de pastille de contact destinée à établir le contact électrique et/ou mécanique avec une couche de conducteur chauffant de l'empilement de couches (116),
- la fourniture du deuxième élément structural (102), lequel possède une bande (104) en cuivre étendue en longueur qui présente, au moins dans une première zone (112), une épaisseur (105) supérieure à 0,1 millimètre transversalement à la direction longitudinale (106),
- l'arrangement de la bande (104) et de la couche (103) l'une au-dessus de l'autre, de sorte que la première zone (112) de la bande (104) et la couche (103) présentent une zone de contact (107) commune l'une avec l'autre,
- l'irradiation d'un rayon laser (108) sur la zone de contact (107) et ainsi :
- la formation d'une liaison soudée (109) qui relie la bande (104) et la couche (103) l'une avec l'autre.

2. Procédé selon la revendication 1, selon lequel le rayon laser (108) est irradié de telle sorte que la forme géométrique de la liaison soudée (109) est configurée en forme d'anneau, en forme de trait, en forme de rectangle ou en forme de cercle.

3. Procédé selon la revendication 1 ou 2, selon lequel le rayon laser (108) est irradié avec des premiers paramètres de laser et ensuite irradié avec des deuxièmes paramètres de laser, qui sont différents des premiers paramètres de laser et qui sont prédéfinis de telle sorte que la liaison soudée (109) est formée.

4. Procédé selon l'une des revendications 1 à 3, selon lequel le rayon laser (108) est irradié en biais.

5. Procédé selon l'une des revendications 1 à 4, selon lequel le rayon laser (108) est irradié sur un côté (111) sur la bande (104) qui se trouve à l'opposé de la couche (103).

6. Procédé selon la revendication 5, selon lequel la fourniture du deuxième élément structural (102) comprend :
- le grainage du côté (111) de la bande (104) qui se trouve à l'opposé de la couche (103) au moyen du rayon laser (108) et/ou chimiquement et/ou mécaniquement.

7. Procédé selon l'une des revendications 1 à 6, selon lequel la fourniture du premier élément structural (101) comprend :
- la pulvérisation thermique de cuivre en vue de former la couche électriquement conductrice (103).

8. Procédé selon l'une des revendications 1 à 7, selon lequel la fourniture du deuxième élément structural (102) comprend :
- la réduction de l'épaisseur (105) dans une zone de soudage (119) de la première zone (112) de la bande (104), et
- la formation de la liaison soudée (109) dans la zone de soudage (119).

9. Procédé selon la revendication 8, comprenant :
- la réduction de l'épaisseur (105) dans la zone de soudage (119) à une deuxième épaisseur (120) prédéfinie transversalement à la direction longitudinale (106), la deuxième épaisseur (120) étant prédéfinie en fonction d'une épaisseur (121) de la couche électriquement conductrice (103) pulvérisée thermiquement et la deuxième épaisseur (120) étant inférieure à l'épaisseur (121) de la couche électriquement conductrice (103) pulvérisée thermiquement.

10. Dispositif pour un appareil de chauffage pour un véhicule automobile, comprenant :
- un empilement de couches (116) comprenant une couche de conducteur chauffant et une couche isolante,
- une couche électriquement conductrice (103) pulvérisée thermiquement, qui sert de pastille de contact destinée à établir le contact électrique et/ou mécanique avec la couche de conducteur chauffant,
- une bande (104) en cuivre qui présente, au moins dans une première zone (112), une épaisseur (105) supérieure à 0,1 millimètre transversalement à la direction longitudinale (106),
- une liaison soudée par laser (109) qui relie la couche (103) et la première zone (112) de la bande (104) l'une avec l'autre afin de former, au moyen de la bande (104), un contact électrique et/ou mécanique contre la couche (103).

11. Dispositif selon la revendication 10, dans lequel la bande (104) possède une deuxième zone (113) en-dehors de la liaison soudée (109), la bande (104) dans la deuxième zone (113) présentant une épaisseur (114) transversalement à la direction longitudinale (106) qui est supérieure à l'épaisseur (105) dans la première zone (112).

12. Dispositif selon la revendication 10 ou 11, dans lequel la couche électriquement conductrice (103) pulvérisée thermiquement possède du cuivre.

13. Dispositif selon l'une des revendications 10 à 12, dans lequel :
- la bande (104) dans une zone de soudage (119) de la première zone (112) présente une deuxième épaisseur (120) qui est inférieure à l'épaisseur (105), et
- la liaison soudée (109) est formée dans la zone de soudage (119).

14. Dispositif selon la revendication 13, dans lequel :
- la deuxième épaisseur (120) est prédéfinie en fonction d'une épaisseur (121) de la couche électriquement conductrice (103) pulvérisée thermiquement, et
- la deuxième épaisseur (120) est inférieure à l'épaisseur (121) de la couche électriquement conductrice (103) pulvérisée thermiquement.

15. Dispositif selon l'une des revendications 10 à 14, comprenant une couche de conducteur chauffant (102) sur laquelle est disposée la couche électriquement conductrice (103),
- un contour de la couche électriquement conductrice (103) étant prédéfini, en vue de prévenir une accumulation de chaleur au niveau de la couche électriquement conductrice (103), par au moins l'un parmi les paramètres suivants :
- une largeur prédéfinie d'un côté avant de la couche électriquement conductrice (103), laquelle fait face à une zone centrale (114) de la couche de conducteur chauffant,
- un écart prédéfini par rapport à un joint de séparation de la couche de conducteur chauffant, et
- une courbure prédéfinie du contour.
